# EUROPEAN PATENT APPLICATION

(11) **EP 4 175 037 A1**
(43) Date of publication of application: **03.05.2023**
(21) Application number: 21832363.2
(22) Date of filing: 29.06.2021
(51) Int. Cl.: H01M 50/24, H01M 50/502

(54) **BATTERY PACK**

(30) Priority: 30.06.2020 CN 202010620245; 23.01.2021 CN 202110094005
(71) Applicant: Zhejiang Lera New Energy Power Technology Co., Ltd., Ningbo, Zhejiang 315000 (CN)
(72) Inventor: KE, Hengzhao, Ningbo, Zhejiang 315000 (CN); DAI, Jianhong, Ningbo, Zhejiang 315000 (CN)
(74) Representative: Elzaburu S.L.P.
(86) International application number: PCT/CN2021/103009
(87) International publication number: WO 2022/002023

(57) **Abstract**

The present disclosure provides a battery pack including a housing, and a battery cell or battery cell assembly and a circuit board that are disposed in the housing, and further including: a first electrical connector connecting one of the positive and negative electrodes of the battery cell or battery cell assembly to the circuit board; a second electrical connector connecting the other one of the positive and negative electrodes of the battery cell or battery cell assembly to the circuit board; and a third electrical connector disposed on the circuit board and adapted to be electrically connected to an external electrical device to supply power from the battery cell to the electrical device through the third electrical connector. The third electrical connector includes a socket terminal in press fit with a pin terminal of the external electrical device. The technical solution involves supplying power from the battery cell to the electrical device through the third electrical connector, and the socket terminal facilitates the sealing design, such as dustproof sealing and waterproof sealing at the port of the battery pack.

## Description

### TECHNICAL FIELD

The present disclosure relates to the technical field of battery packs and in particular to a battery pack.

### BACKGROUND

To improve the versatility of power tools and make the working range of power tools not limited by the location of the socket, many power tools on the market are powered by battery packs. Power tools are easy to carry and simple to operate and have multiple functions, which can greatly reduce labor intensity, improve work efficiency, and mechanize manual operation, making them widely used in construction, housing decoration, automobile, machinery, electric power, bridge, gardening, and other fields, as well as in domestic use. Whether the battery pack is suitable or not and whether it is firmly assembled are crucial for power tools. Generally, the existing battery pack for the power tool is directly fixed on the power tool, which is not convenient for replacement. In addition, due to its large size, the battery pack is inconvenient for charging and discharging, and thus, cannot supply power to a variety of power tools. Furthermore, the existing battery pack has a single function and complex structure.

### SUMMARY

The purpose of the present disclosure is to provide a battery pack facilitating sealing management.

The present disclosure provides a battery pack including a housing, and a battery cell or battery cell assembly and a circuit board that are disposed in the housing, and further including:
A first electrical connector connecting one of positive and negative electrodes of the battery cell or battery cell assembly to the circuit board;
A second electrical connector connecting the other one of the positive and negative electrodes of the battery cell or battery cell assembly to the circuit board; and
A third electrical connector disposed on the circuit board and adapted to be electrically connected to an external electrical device, to supply power from the battery cell to the electrical device through the third electrical connector, where
the third electrical connector includes a socket terminal in press fit with a pin terminal of the external electrical device.

Further, the socket terminal includes an annular contact portion adapted to be conductively connected to the pin terminal. The pin terminal is inserted into the socket terminal, and an annular contact surface of the annular contact portion annularly wraps the pin terminal.

Further, the annular contact portion protrudes toward the center of the socket terminal and is adapted to deform, and the pin terminal is pressed into the annular contact portion by an external force and deforms the annular contact portion.

Further, plugging pressure F between the pin terminal and the socket terminal satisfies 8N≤F≤12N.

Further, the third electrical connector includes a conductive connection portion fixed to the circuit board and a barrel connection portion electrically connected to the pin terminal. The conductive connection portion is conductively connected to the barrel connection portion, and the barrel connection portion has a hole depth of not less than 4 mm.

Further, the barrel connection portion includes a conductive barrel and an expansion core located in the conductive barrel, and the expansion core is adapted to deform under the action of an external force.

Further, the expansion core includes a plurality of conductive elastic sheets, which are arranged in an annular array at intervals and protrude toward the center of the annular array. The pin terminal is pressed into the center of the annular array under the action of an external force, and the protruding portions are squeezed open and elastically wrap the pin terminal.

Compared with the prior art, the present disclosure has the following beneficial technical effects:
In the present disclosure, the third electrical connector adapted to be electrically connected to the external electrical device includes the socket terminal, which is in press fit with the pin terminal of the external electrical device, such that power from the battery cell can be supplied to the electrical device through the third electrical connector. The socket terminal facilitates the sealing design, such as dustproof sealing and waterproof sealing at the port of the battery pack.

Another purpose of the present disclosure is to provide a battery pack facilitating dustproof and waterproof management.

The present disclosure provides a battery pack including a housing, and a battery cell or battery cell assembly and a circuit board that are disposed in the housing, and further including:
A first electrical connector connecting one of positive and negative electrodes of the battery cell or battery cell assembly to the circuit board;
A second electrical connector connecting the other one of the positive and negative electrodes of the battery cell or battery cell assembly to the circuit board; and
A third electrical connector disposed on the circuit board and adapted to be electrically connected to an external electrical device, to supply power from the battery cell to the electrical device through the third electrical connector, where
the third electrical connector includes an open port facing the outside of and in communication with the housing, and a closed end away from the open port. The open port is suitable for terminal insertion by the external electrical device, and the closed end extends to be conductively fixed to the circuit board.

Further, the third electrical connector includes a body and a conductive terminal integrally connected to the body and opposite to the open port, and the conductive terminal is at least partially wrapped and sealed by the body.

Further, the conductive terminal is integrally molded with the body.

Further, the conductive terminal includes a conductive connection portion fixed to the circuit board and a barrel connection portion electrically connected to the pin terminal. The barrel connection portion includes a conductive barrel and an expansion core located in the conductive barrel, and the expansion core is adapted to deform under the action of an external force.

Further, the expansion core includes a plurality of conductive elastic sheets, which are arranged in an annular array at intervals and protrude toward the center of the annular array. The pin terminal is pressed into the center of the annular array under the action of an external force, and the protruding portions are squeezed open and elastically wrap the pin terminal.

Further, a sealing gasket is sandwiched between the third electrical connector and the housing, and the sealing gasket is adapted to seal a mounting gap between the open port and the housing.

Compared with the prior art, the present disclosure has the following beneficial technical effects:
In the present disclosure, the third electrical connector adapted to be electrically connected to the external electrical device includes the open port facing the outside of and in communication with the housing, and the closed end away from the open port. The open port is suitable for terminal insertion by the external electrical device, such that power from the battery cell can be supplied to the electrical device through the third electrical connector. The closed end extends to be conductively fixed to the circuit board to achieve circuit conduction. The third electrical connector includes only one open port facing the outside of the housing, and the other end is closed, thereby realizing effective dustproof and waterproof management.

Another purpose of the present disclosure is to provide a battery pack with a reasonable structural layout.

The present disclosure provides a battery pack including a housing, and a battery cell or battery cell assembly and a circuit board that are disposed in the housing, and further including:
A first electrical connector connecting one of positive and negative electrodes of the battery cell or battery cell assembly to the circuit board;
A second electrical connector connecting the other one of the positive and negative electrodes of the battery cell or battery cell assembly to the circuit board;
A third electrical connector disposed on the circuit board and adapted to be electrically connected to an external electrical device, to supply power from the battery cell to the electrical device through the third electrical connector; and
A fourth electrical connector disposed on the circuit board and adapted to be electrically connected to an external power supply, to charge the battery cell through the fourth electrical connector, where
the third electrical connector and the fourth electrical connector are stacked on the same side of the battery pack.

Further, the circuit board includes a mounting notch corresponding to the fourth electrical connector, which is mounted correspondingly in the mounting notch and has one end surface at least partially flush with the circuit board, and the third electrical connector is stacked on the end surface.

Further, the third electrical connector includes an open port facing the outside of and in communication with the housing, and a closed end away from the open port. The open port is suitable for terminal insertion by the external electrical device, and the closed end extends to be conductively fixed to the circuit board.

Further, the third electrical connector includes a body and a conductive terminal connected to the body. The conductive terminal has an open end and a closed end. The open end is sealed and wrapped by the body, and the closed end at least partially extends through the body to be conductively fixed to the circuit board.

Further, the closed end of the conductive terminal is welded and fixed to the circuit board in a circular arc of 90 degrees.

Further, the body is respectively provided with lugs on both sides in a width direction of the circuit board. The lugs and the circuit board are correspondingly provided with connection holes for connection members to pass through, and the connection members correspondingly pass through the connection holes to fix the body and the circuit board.

Further, the third electrical connector and the fourth electrical connector are stacked at a height of 8 mm to 10 mm.

Compared with the prior art, the present disclosure has the following beneficial technical effects:
In the present disclosure, the third electrical connector and the fourth electrical connector are stacked on the same side of the battery pack. The third electrical connector is adapted to be electrically connected to the external electrical device to supply power from the battery cell to the electrical device through the third electrical connector. The fourth electrical connector is adapted to be electrically connected to an external charging source to charge the battery cell through the fourth electrical connector. In this way, the other side of the battery pack in the present disclosure can be used for other purposes, for example, another USB-A interface may be disposed thereon.

### BRIEF DESCRIPTION OF THE DRAWINGS

FIG. 1 is a stereoscopic view of a battery pack according to an embodiment of the present disclosure.
FIG. 2 is an exploded view 1 of a battery pack according to an embodiment of the present disclosure.
FIG. 3 is an exploded view 2 of a battery pack according to an embodiment of the present disclosure.
FIG. 4 is a structural diagram of a circuit board according to an embodiment of the present disclosure.
FIG. 5 is a structural diagram of a third electrical connector according to an embodiment of the present disclosure.
FIG. 6 is a structural diagram of a circuit board and a support framework according to an embodiment of the present disclosure.
FIG. 7 is a schematic diagram of a battery pack matching a pin terminal according to an embodiment of the present disclosure.
FIG. 8 is a cross-sectional view of a battery pack separated from a pin terminal according to an embodiment of the present disclosure.
FIG. 9 is a cross-sectional view of a battery pack matching a pin terminal according to an embodiment of the present disclosure.
FIG. 10 is a cross-sectional view of a structure of a third electrical connector according to an embodiment of the present disclosure.
FIG. 11 is an exploded view of a structure of a third electrical connector according to an embodiment of the present disclosure.
FIG. 12 is an exploded view of an embodiment of the present disclosure.
FIG. 13 is another exploded view of an embodiment of the present disclosure.

### DETAILED DESCRIPTION OF THE EMBODIMENTS

The specific implementations of the present disclosure are described in more detail below with reference to the accompanying drawings and examples. The following embodiments are illustrative of the present disclosure and should not be construed as limiting the scope of the present disclosure.

### Embodiment 1:

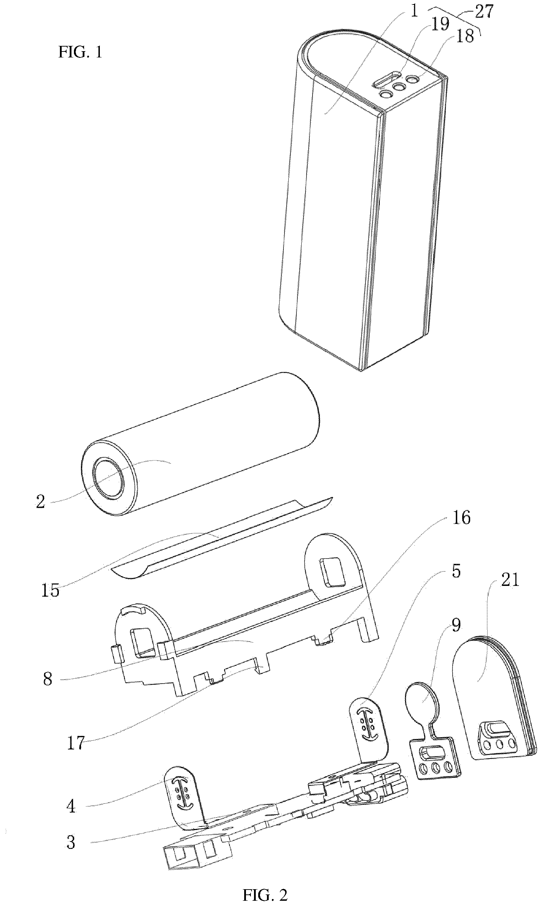

As shown in FIG. 1, FIG. 2, FIG. 3, FIG. 4, and FIG. 5, a battery pack according to an embodiment of the present disclosure includes housing 1, battery cell 2 and circuit board 3 that are disposed in the housing 1, and further includes:
First electrical connector 4 connecting one of the positive and negative electrodes of the battery cell 2 to the circuit board 3; and
Second electrical connector 5 connecting the other one of the positive and negative electrodes of the battery cell 2 to the circuit board 3.

As shown in FIG. 1, in this embodiment, third electrical connector 6 disposed on the circuit board 3 includes a body and socket terminal 10 integrally molded with the body. The socket terminal 10 is used to be electrically connected to an external electrical device to supply power from the battery cell 2 to the electrical device through the third electrical connector. Fourth electrical connector 7 disposed on the circuit board 3 includes at least one second interface 12. The second interface 12 is used to be electrically connected to an external electrical device and a charging source to supply power to the electrical device through the second interface 12 and charge the battery cell 2 through the second interface 12. According to the actual product demand, the third electrical connector 6 and the fourth electrical connector 7 may be disposed on the same side or opposite sides of the battery pack.

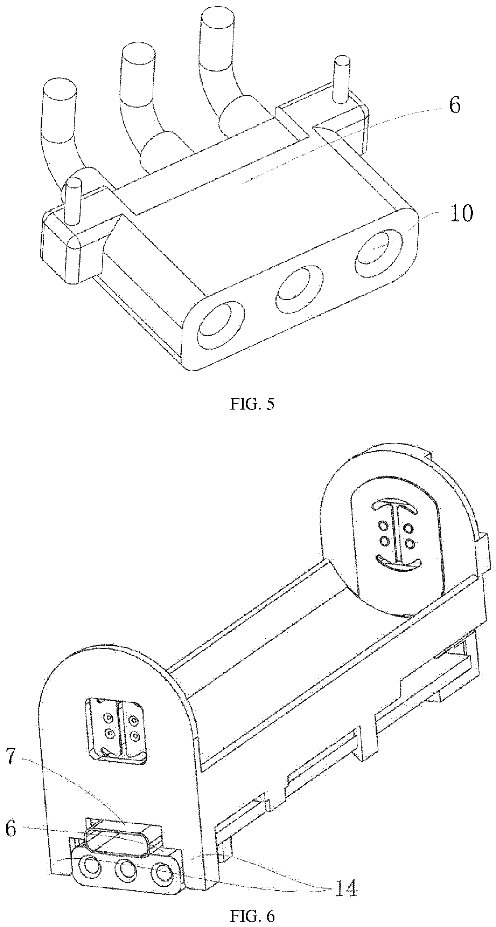

The second interface 12 in this embodiment can be used for both discharging and charging. Specifically, the second interface 12 is a type-C interface. As shown in FIG. 5, the socket terminal 10 is used to supply power to various handheld power tools, such as cordless vacuum cleaners, DC air compressors, and other garden tools. In addition, the socket terminal can effectively improve the waterproof sealing effect of the battery pack and is convenient for plugging. The battery pack of this embodiment has a compact structure and can be used as a mobile power supply. In this case, the second interface 12, that is, the type-C interface, can be used to charge mobile devices, such as cell phones or tablets, or the battery cell 2 of the battery pack.

Specifically, the battery pack in this embodiment further includes support framework 8 adapted to receive the battery cell 2 and the circuit board 3. As shown in FIG. 2, the battery cell 2 is a single 21700 cell. An upper portion of the support framework 8 is an arc-shaped groove for receiving the battery cell 2, and insulation pad 15 is disposed between the support framework 8 and the battery cell 2 to achieve leakage protection, especially when the skin of the battery cell 2 is damaged.

In this embodiment, to support the circuit board 3 on the support framework 8 with a spacing, two protruding support clamping blocks 16 are disposed on two sides at the bottom of the support framework 8, and two clamping plates 17 are disposed on two sides at the bottom of the support framework 8. The support clamping blocks 16 are used to separate the circuit board 3 from the support framework 8, that is, the step-shaped support clamping blocks 16 are used to define the spacing between the circuit board 3 and the support framework 8, and the clamping plates 17 are used to fasten the circuit board 3 to the support framework 8. The spacing between the circuit board 3 and the support framework 8 is H, and H is not greater than 2 mm. In this embodiment, H=1.57 mm. The spacing H effectively ensures a heat dissipation effect between the circuit board 3 and the battery cell 2.

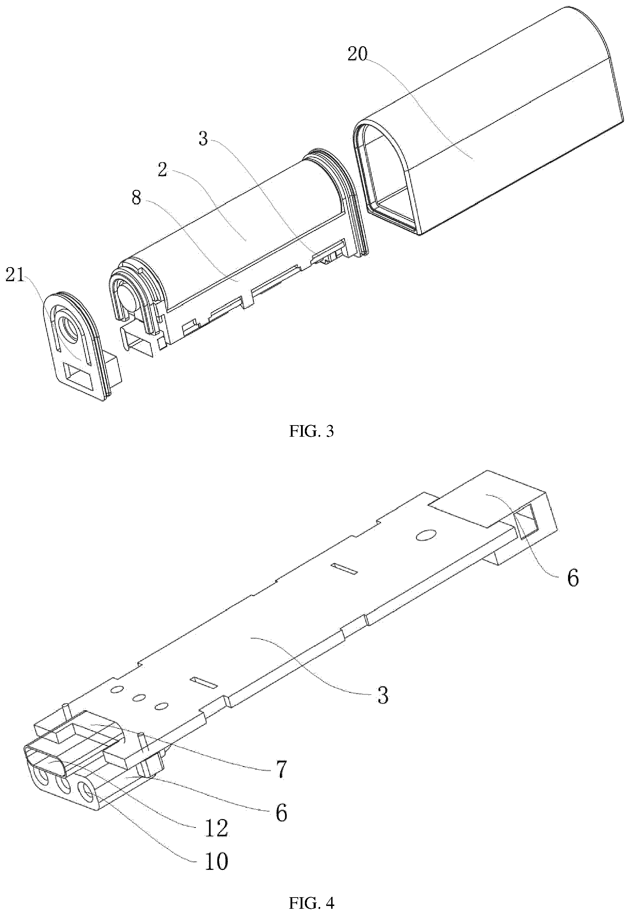

As shown in FIG. 2 and FIG. 4, the socket terminal 10 and/or the second interface 12 extend(s) outward along an axial direction of the positive and negative electrodes of the battery cell 2. The second interface 12 protrudes outward along the axial direction of the positive and negative electrodes of the battery cell 2, that is, both the socket terminal 10 and the second interface 12 are plugged along the longest side of the battery pack, which is more convenient for use.

In this embodiment, the housing 1 is provided with connector openings 27 corresponding to the third electrical connector 6 and the fourth electrical connector 7. Specifically, the connector openings 27 include first opening 18 and second opening 19, the second interface 12 corresponds to the second opening 19, and the socket terminal 10 corresponds to the first opening 18. In addition, the second interface 12 and the socket terminal 10 are disposed side by side at the same end of the battery pack. In this way, the socket terminal 10 and the second interface 12 are provided to realize the multi-functional application of the battery pack in this embodiment, and the overall structure is compact, simple, and convenient to use.

In addition, a mounting gap is provided between the third electrical connector 6 and the support framework 8, as well as between the fourth electrical connector 7 and the support framework 8. Specifically, the fourth electrical connector 7 is slightly higher than the third electrical connector 6, and the mounting gap between the third electrical connector 6 and the support framework 8 and between the fourth electrical connector 7 and the support framework 8 is sealed by waterproof gasket 9. The waterproof gasket 9 is provided with slots corresponding to the third electrical connector 6 and the fourth electrical connector 7, and the waterproof gasket 9 is sleeved on the fourth electrical connector 7, that is, the portion of the fourth electrical connector 7 slightly higher than the third electrical connector 6. The waterproof gasket 9 deforms under slight compression between the support framework 8 and the housing 1 to completely seal the mounting gap. In addition, the waterproof gasket 9 abuts against the side walls of the third electrical connector 6 and the fourth electrical connector 7 to further ensure the sealing effect. The fourth electrical connector 7 is used for positioning and mounting.

The battery pack in this embodiment uses the battery cell 2 to supply power, which is the single 21700 cell, thus the applicable power tools are not limited to cordless handheld power tools, but also include garden tools, cordless vacuum cleaners, DC air compressors, and other power devices using the secondary battery as the power supply. This greatly improves the application scope of the battery pack, the overall structure is simple, and the battery pack can be used as a portable mobile power supply that is compact and more functional.

In addition, the first electrical connector 4 and the second electrical connector 5 include at least longitudinal bending sections extending along the axial direction of the positive and negative electrodes of the battery cell 2, that is, the first electrical connector 4 and the second electrical connector 5 bending in right angle are used to connect the positive and negative electrodes of the battery cell to the circuit board 3.

### Embodiment 2:

Compared with Embodiment 1, in this embodiment, the third electrical connector 6 disposed on the battery pack includes two interfaces, including socket terminal 10 and a USB interface. As shown in FIG. 4, the socket terminal 10 and the USB interface are disposed at two ends of the battery pack, the socket terminal 10 is disposed as in Embodiment 1, and the USB interface is disposed at the end opposite the socket terminal 10 on the battery pack.

The USB interface is disposed to further improve the application scope of the battery pack as a mobile power supply.

### Embodiment 3:

Compared with Embodiment 1, in this embodiment, the housing 1 includes first housing 20 for accommodating the battery cell 2, and at least one second housing 21. The second housing 21 is disposed at the positive electrode and/or negative electrode of the battery cell 2, and the first housing 20 and the second housing 21 form a closed cavity for accommodating the battery cell 2. Specifically, as shown in FIG. 3, in this embodiment, there is only one first housing 20 and only one second housing 21. The second housing 21 is disposed at the positive or negative electrode of the battery cell 2, and there is a curved and closed separation edge between the first housing 20 and the second housing 21. The separation edge is in the same plane, and the plane of the separation edge is parallel to the planes of the positive and negative electrodes of the battery cell 2, that is, the edge of the second housing 21 is the separation edge that fits the first housing 20. The plane of the second housing 21 is perpendicular to the axial direction of the positive and negative electrodes of the battery cell 2, and the first housing 20 is barrel-shaped. The outer surface of the radial circumference of the housing 1 accommodating the battery cell 2 has no separation edge. The first housing 20 is an integral structure, and the second housing 21 is embedded and fixed at the end of the first housing 20. Specifically, the first housing 20 and the second housing 21 are fixed by mutual nesting and clamping through a clamp structure, and the separation edge between the first housing 20 and the second housing 21 is located at the outer end surface of the housing 1. In this embodiment, there is no visible separation edge on the side wall of the housing 1, reflecting the integral design, which has a better grip feeling when used as a mobile power supply.

The first housing 20 and the second housing 21 are sealingly connected through ultrasonic welding to further improve the overall sealing performance.

### Embodiment 4:

Compared with Embodiment 1, in this embodiment, an end of the support framework 8 extends and is provided with fixed frame 14 and adapted to clamp and limit the third electrical connector 6 and the fourth electrical connector 7. As shown in FIG. 6, the third electrical connector 6 and the fourth electrical connector 7 are stacked on the same side of the battery pack. The fixed frame 14 includes two fixed feet extending downward from the end of the support framework 8, and the space between the two fixed feet is used to clamp and limit the third electrical connector 6 and the fourth electrical connector 7 to achieve positioning and mounting. In addition, the fixed frame 14 presses against the side of the waterproof gasket 9 to further improve the sealing effect of the waterproof gasket 9 on the battery pack.

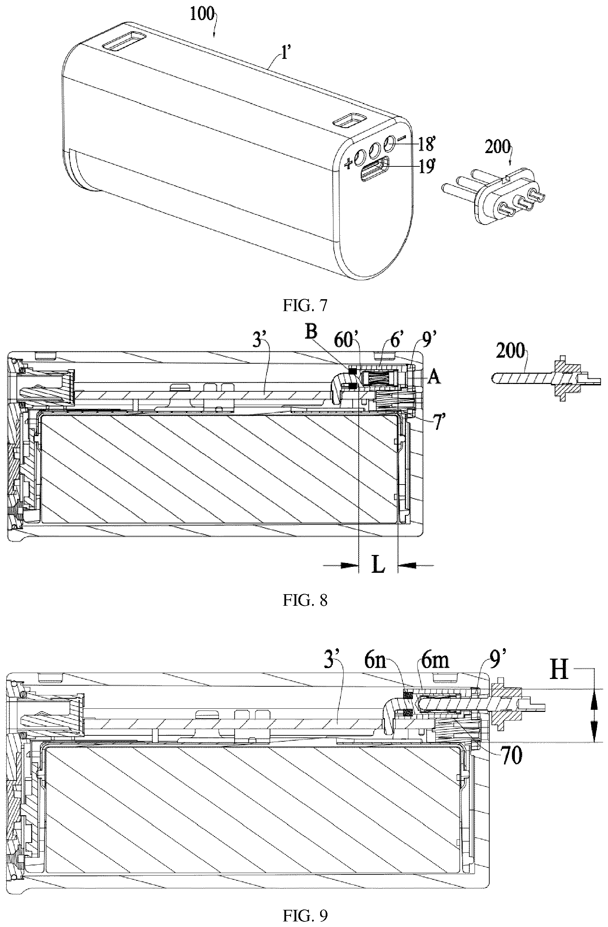

Referring to FIG. 7, FIG. 8, and FIG. 9, battery pack 100 includes housing 1', and battery cell 2' or battery cell assembly and circuit board 3' that are disposed in the housing 1', and further includes:
First electrical connector 4' connecting one of the positive and negative electrodes of the battery cell 2' or battery cell assembly to the circuit board 3';
Second electrical connector 5' connecting the other one of the positive and negative electrodes of the battery cell 2' or battery cell assembly to the circuit board 3'; and
Third electrical connector 6' disposed on the circuit board 3' and adapted to be electrically connected to an external electrical device, to supply power from the battery cell 2' to the electrical device through the third electrical connector 6'.

Referring to FIG. 8 and FIG. 9, the third electrical connector 6' includes socket terminal 60' in press fit with pin terminal 200 of the external electrical device.

Further, the socket terminal 60' includes annular contact portion 60a adapted to be conductively connected to the pin terminal 200, the pin terminal 200 is inserted into the socket terminal 60', and an annular contact surface of the annular contact portion 60a annularly wraps the pin terminal 200.

Further, the annular contact portion 60a protrudes towards the center of the socket terminal 60' and is adapted to deform, and the pin terminal 200 is pressed into the annular contact portion 60a by an external force and deforms the annular contact portion 60a.

Further, plugging pressure F between the pin terminal 200 and the socket terminal 60' satisfies 8N≤F≤12N.

Further, referring to FIG. 8, the third electrical connector 6' includes conductive connection portion 60b fixed to the circuit board 3' and barrel connection portion 60c electrically connected to the pin terminal 200. The conductive connection portion 60b is conductively connected to the barrel connection portion 60c, and the barrel connection portion 60c has a hole depth of not less than 4 mm.

Further, the barrel connection portion 60c includes conductive barrel 601 and expansion core 602 located in the conductive barrel 601, and the expansion core 602 is adapted to deform under the action of an external force.

Further, referring to FIG. 9, FIG. 10, and FIG. 11, the expansion core 602 includes a plurality of conductive elastic sheets 60m, which are arranged in an annular array at intervals and protrude toward the center of the annular array. The pin terminal 200 is pressed into the center of the annular array under the action of an external force, and the protruding portions are squeezed open and elastically wrap the pin terminal 200.

In the present disclosure, the third electrical connector adapted to be electrically connected to the external electrical device includes the socket terminal, which is in press fit with the pin terminal of the external electrical device, such that power from the battery cell can be supplied to the electrical device through the third electrical connector. The socket terminal facilitates the sealing design, such as dustproof sealing and waterproof sealing at the port of the battery pack.

Still referring to FIG. 7 and FIG. 8, battery pack 100 includes: housing 1', and battery cell 2' or battery cell assembly and circuit board 3' that are disposed in the housing 1', and further includes:
First electrical connector 4' connecting one of positive and negative electrodes of the battery cell 2' or battery cell assembly to the circuit board 3';
Second electrical connector 5' connecting the other one of the positive and negative electrodes of the battery cell 2' or battery cell assembly to the circuit board 3'; and
Third electrical connector 6' disposed on the circuit board 3' and adapted to be electrically connected to an external electrical device, to supply power from the battery cell 2' to the electrical device through the third electrical connector 6'.

The third electrical connector 6' includes open port A facing the outside of and in communication with the housing, and closed end B away from the open port A. The open port A is suitable for terminal insertion by the external electrical device, and the closed end B extends to be conductively fixed to the circuit board 3'.

Further, referring to FIG. 9, FIG. 10, and FIG. 11, the third electrical connector 6' includes body 6m and conductive terminal 6n integrally connected to the body 6m and opposite to the open port A. The conductive terminal 6n is at least partially wrapped and sealed by the body 6m.

Further, the conductive terminal 6n is integrally molded with the body 6m.

Further, the conductive terminal 6n includes conductive connection portion 60b fixed to the circuit board 3' and barrel connection portion 60c electrically connected to the pin terminal 200. The barrel connection portion 60c includes conductive barrel 601 and expansion core 602 located in the conductive barrel 601, and the expansion core 602 is adapted to deform under the action of an external force.

Further, referring to FIG. 9, the expansion core 602 includes a plurality of conductive elastic sheets 60m, which are arranged in an annular array at intervals and protrude toward the center of the annular array. The pin terminal 200 is pressed into the center of the annular array under the action of an external force, and the protruding portions are squeezed open and elastically wrap the pin terminal 200.

Further, sealing gasket 9' is sandwiched between the third electrical connector 6' and the housing 1', and the sealing gasket 9' is adapted to seal a mounting gap between the open port A and the housing 1'.

In the present disclosure, the third electrical connector adapted to be electrically connected to the external electrical device includes the open port facing the outside of and in communication with the housing, and the closed end away from the open port. The open port is suitable for terminal insertion by the external electrical device, such that power from the battery cell can be supplied to the electrical device through the third electrical connector. The closed end extends to be conductively fixed to the circuit board to achieve circuit conduction. The third electrical connector includes only one open port facing the outside of the housing, and the other end is closed, thereby realizing effective dustproof and waterproof management.

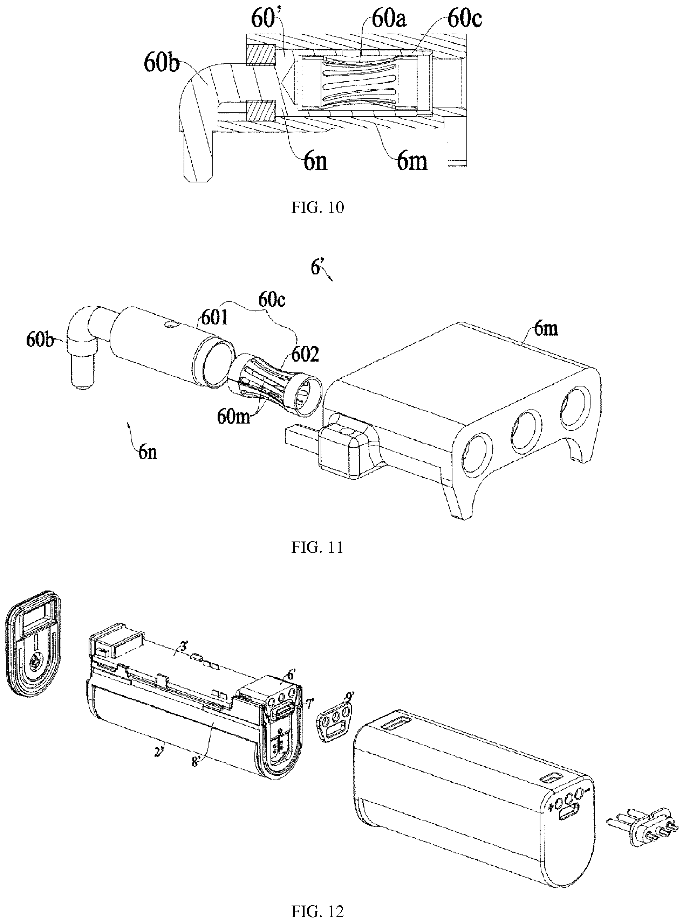

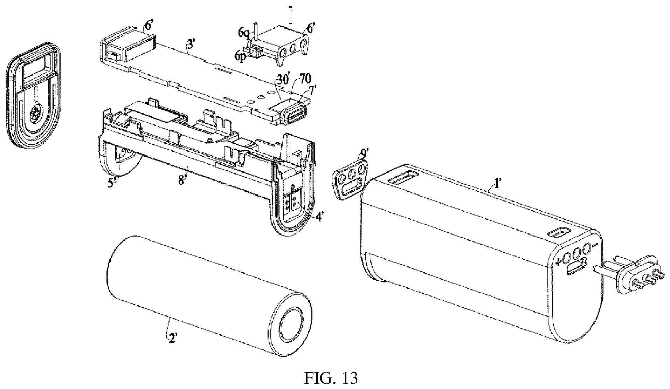

Referring to FIG. 12 and FIG. 13, battery pack 100 includes: housing 1', and battery cell 2' or battery cell assembly and circuit board 3' that are disposed in the housing 1', and further includes:
First electrical connector 4' connecting one of the positive and negative electrodes of the battery cell 2' or battery cell assembly to the circuit board 3';
Second electrical connector 5' connecting the other one of the positive and negative electrodes of the battery cell 2' or battery cell assembly to the circuit board 3';
Third electrical connector 6' disposed on the circuit board 3' and adapted to be electrically connected to an external electrical device, to supply power from the battery cell 2' to the electrical device through the third electrical connector 6'; and
Fourth electrical connector 7' disposed on the circuit board 3' and adapted to be electrically connected to an external power supply, to charge the battery cell through the fourth electrical connector 7'.

The third electrical connector 6' and the fourth electrical connector 7' are stacked on the same side of the battery pack 100.

Further, the circuit board 3' includes mounting notch 30' corresponding to the fourth electrical connector 7'. The fourth electrical connector 7' is mounted correspondingly in the mounting notch 30' and has one end surface 70 at least partially flush with the circuit board 3', and the third electrical connector 6' is stacked on the end surface 70.

The third electrical connector 6' includes open port A facing the outside of and in communication with the housing 1', and closed end B away from the open port A. The open port A is suitable for terminal insertion by the external electrical device, and the closed end B extends to be conductively fixed to the circuit board 3'.

Further, the third electrical connector 6' includes body 6m and conductive terminal 6n integrally connected to the body 6m. The conductive terminal 6n has an open end and a closed end. The open end is sealed and wrapped by the body 6m, and the closed end at least partially extends through the body 6m to be conductively fixed to the circuit board 3'.

Further, the closed end of the conductive terminal 6n is welded and fixed to the circuit board 3' in a circular arc of 90 degrees.

Further, the body 6m is respectively provided with lugs 6p on both sides in a width direction of the circuit board 3'. The lugs 6p and the circuit board 3' are correspondingly provided with connection holes for connection members 6q to pass through, and the connection members 6q correspondingly pass through the connection holes to fix the body 6m and the circuit board 3'.

Further, the third electrical connector 6' and the fourth electrical connector 7' are stacked in height H of 8 mm to 10 mm.

In the present disclosure, the third electrical connector and the fourth electrical connector are stacked on the same side of the battery pack. The third electrical connector is adapted to be electrically connected to the external electrical device to supply power from the battery cell to the electrical device through the third electrical connector. The fourth electrical connector is adapted to be electrically connected to an external charging source to charge the battery cell through the fourth electrical connector. In this way, the other side of the battery pack in the present disclosure can be used for other purposes, for example, another USB-A interface may be disposed thereon.

In addition, the fourth electrical connector 7' is preferably a type-c interface, which is not only adapted to be electrically connected to an external charging source to charge the battery cell through the fourth electrical connector 7' but also adapted to be electrically connected to the external electrical device to supply power from the battery cell 2' to the electrical device through the fourth electrical connector 7'.

The above descriptions are merely preferred implementations of the present disclosure. It should be noted that a person of ordinary skill in the art may further make several improvements and modifications without departing from the principle of the present disclosure, but such improvements and modifications should be deemed as falling within the protection scope of the present disclosure.

## Claims

1. A battery pack, comprising a housing, and a battery cell or battery cell assembly and a circuit board that are disposed in the housing, and further comprising:
a first electrical connector connecting one of positive and negative electrodes of the battery cell or battery cell assembly to the circuit board;
a second electrical connector connecting the other of the positive and negative electrodes of the battery cell or battery cell assembly to the circuit board; and
a third electrical connector disposed on the circuit board and adapted to be electrically connected to an external electrical device, to supply power from the battery cell to the electrical device through the third electrical connector, wherein
the third electrical connector comprises a socket terminal in press fit with a pin terminal of the external electrical device.

2. The battery pack according to claim 1, wherein the socket terminal comprises an annular contact portion adapted to be conductively connected to the pin terminal, the pin terminal is inserted into the socket terminal, and an annular contact surface of the annular contact portion annularly wraps the pin terminal.

3. The battery pack according to claim 2, wherein the annular contact portion protrudes toward a center of the socket terminal and is adapted to deform, and the pin terminal is pressed into the annular contact portion by an external force and deforms the annular contact portion.

4. The battery pack according to any one of claims 1 to 3, wherein plugging pressure F between the pin terminal and the socket terminal satisfies 8N≤F≤12N.

5. The battery pack according to claim 1, wherein the third electrical connector comprises a conductive connection portion fixed to the circuit board and a barrel connection portion electrically connected to the pin terminal, the conductive connection portion is conductively connected to the barrel connection portion, and the barrel connection portion has a hole depth of not less than 4 mm.

6. The battery pack according to claim 5, wherein the barrel connection portion comprises a conductive barrel and an expansion core located in the conductive barrel, and the expansion core is adapted to deform under the action of an external force.

7. The battery pack according to claim 6, wherein the expansion core comprises a plurality of conductive elastic sheets, the plurality of conductive elastic sheets is arranged in an annular array at intervals and protrude toward a center of the annular array, the pin terminal is pressed into the center of the annular array under the action of an external force, and the protruding portions are squeezed open and elastically wrap the pin terminal.

8. A battery pack, comprising a housing, and a battery cell or battery cell assembly and a circuit board that are disposed in the housing, and further comprising:
a first electrical connector connecting one of positive and negative electrodes of the battery cell or battery cell assembly to the circuit board;
a second electrical connector connecting the other one of the positive and negative electrodes of the battery cell or battery cell assembly to the circuit board; and
a third electrical connector disposed on the circuit board and adapted to be electrically connected to an external electrical device to supply power from the battery cell to the electrical device through the third electrical connector, wherein
the third electrical connector comprises an open port facing the outside of and in communication with the housing, and a closed end away from the open port, the open port is suitable for terminal insertion by the external electrical device, and the closed end extends to be conductively fixed to the circuit board.

9. The battery pack according to claim 8, wherein the third electrical connector comprises a body and a conductive terminal integrally connected to the body and opposite to the open port, and the conductive terminal is at least partially wrapped and sealed by the body.

10. The battery pack according to claim 8, wherein the conductive terminal is integrally molded with the body.

11. The battery pack according to claim 9, wherein the conductive terminal comprises a conductive connection portion fixed to the circuit board and a barrel connection portion electrically connected to the pin terminal, the barrel connection portion comprises a conductive barrel and an expansion core located in the conductive barrel, and the expansion core is adapted to deform under the action of an external force.

12. The battery pack according to claim 11, wherein the expansion core comprises a plurality of conductive elastic sheets, the plurality of conductive elastic sheets is arranged in an annular array at intervals and protrude toward a center of the annular array, the pin terminal is pressed into the center of the annular array under the action of an external force, and the protruding portions are squeezed open and elastically wrap the pin terminal.

13. The battery pack according to claim 8 or 9, wherein a sealing gasket is sandwiched between the third electrical connector and the housing, and the sealing gasket is adapted to seal a mounting gap between the open port and the housing.

14. A battery pack, comprising a housing, and a battery cell or battery cell assembly and a circuit board that are disposed in the housing, and further comprising:
a first electrical connector connecting one of positive and negative electrodes of the battery cell or battery cell assembly to the circuit board;
a second electrical connector connecting the other one of the positive and negative electrodes of the battery cell or battery cell assembly to the circuit board;
a third electrical connector disposed on the circuit board and adapted to be electrically connected to an external electrical device to supply power from the battery cell to the electrical device through the third electrical connector; and
a fourth electrical connector disposed on the circuit board and adapted to be electrically connected to an external power supply to charge the battery cell through the fourth electrical connector, wherein
the third electrical connector and the fourth electrical connector are stacked on a same side of the battery pack.

15. The battery pack according to claim 14, wherein the circuit board comprises a mounting notch corresponding to the fourth electrical connector, the fourth electrical connector is mounted correspondingly in the mounting notch and has one end surface at least partially flush with the circuit board, and the third electrical connector is stacked on the end surface.

16. The battery pack according to claim 15, wherein the third electrical connector comprises an open port facing the outside of and in communication with the housing, and a closed end away from the open port, the open port is suitable for terminal insertion by the external electrical device, and the closed end extends to be conductively fixed to the circuit board.

17. The battery pack according to claim 16, wherein the third electrical connector comprises a body and a conductive terminal integrally connected to the body, the conductive terminal has an open end and a closed end, the open end is sealed and wrapped by the body, and the closed end at least partially extends through the body to be conductively fixed to the circuit board.

18. The battery pack according to claim 17, wherein the closed end of the conductive terminal is welded and fixed to the circuit board in a circular arc of 90 degrees.

19. The battery pack according to claim 17, wherein the body is respectively provided with lugs on both sides in a width direction of the circuit board, the lugs and the circuit board are correspondingly provided with connection holes for connection members to pass through, and the connection members correspondingly pass through the connection holes to fix the body and the circuit board.

20. The battery pack according to any one of claims 14 to 19, wherein the third electrical connector and the fourth electrical connector are stacked at a height of 8 mm to 10 mm.
